**Europäisches Patentamt**

**European Patent Office**

**Office européen des brevets**

(19)

(11) Veröffentlichungsnummer: **0 268 597**
**B1**

(12) **EUROPÄISCHE PATENTSCHRIFT**

(45) Veröffentlichungstag der Patentschrift: **12.09.90**

(21) Anmeldenummer: **87902395.0**

(22) Anmeldetag: **14.04.87**

(86) Internationale Anmeldenummer:
**PCT/DE87/00170**

(87) Internationale Veröffentlichungsnummer:
**WO 87/07406 03.12.87 Gazette 87/27**

(51) Int. Cl.⁵: **G 06 F 11/00**

(54) **VERFAHREN ZUM ABSPEICHERN VON DATEN.**

(30) Priorität: **20.05.86 DE 3616895**

(43) Veröffentlichungstag der Anmeldung:
**01.06.88 Patentblatt 88/22**

(45) Bekanntmachung des Hinweises auf die
Patenterteilung:
**12.09.90 Patentblatt 90/37**

(84) Benannte Vertragsstaaten:
**DE FR GB**

(56) Entgegenhaltungen:
**EP-A-0 026 980**
**EP-A-0 039 449**
**DE-A-2 220 150**
**US-A-4 096 578**

(73) Patentinhaber: **ROBERT BOSCH GMBH**
**Postfach 50**
**D-7000 Stuttgart 1 (DE)**

(72) Erfinder: **BRÄUNINGER, Jürgen**
**Kaiserslauterer Str. 60**
**D-7000 Stuttgart 31 (DE)**

## Beschreibung

### Stand der Technik

Die Erfindung betrifft ein Verfahren zum Abspeichern von Daten gemäß der Gattung des Hauptanspruchs.

In Steuergeräten mit Rechner und damit verbundenem Speicher können beim Abspeichern eines Datums in einer Speicherzelle durch Abschalten der Versorgungsspannung fehlerhafte oder unvollständige Daten abgespeichert werden. Das Abspeichern eines Datums in einer Speicherzelle des Speichers kann zum Beispiel 10 ms dauern. Wird während dieser Zeit die Spannung abgeschaltet oder durch eine Störung beeinträchtigt, so kann die Speicherzelle anschließend einen undefinierbaren Wert enthalten. D.h. es ist dann in allgemeinen weder das neue Datum abgespeichert noch das alte Dateum erhalten geblieben.

Zur Sicherung der abzuspeichernden Daten ist es bekannt, diese Daten mehrfache abzuspeichern und bei Wiederanlegen der Spannung die Wiederherstellung des Speicherinhalts aufgrund von Mehrheitsentscheidungen durchzuführen. Beispielsweise kann die Mehrfachabspeicherung in 3 Adressen erfolgen, so daß bei Wiederanlegen der Spannung der Speicherinhalt übernommen wird, der wenigstens in 2 Speicherzellen enthalten ist. Eine derartige Mehrfachabspeicherung erfordert jedoch einen beträchtlichen Aufwand an Speicherplatz und Speicherzeit.

### Vorteile der Erfindung

Das erfindungsgemäße Verfahren ist durch die im Hauptanspruch angegebenen Merkmale gekennzeichnet und hat demgegenüber den Vorteil, daß mit sehr geringem Mahraufwand an Speicherplatz die Daten während des Abspeichervorgangs gesichert sind und jederzeit eine Wiederherstellung eines durch Abschalten der Versorgungsspannung verlorengegangenen Inhalts einer Speicherzelle möglich ist. Es können drei Zwischenspeicherzellen vorgesehen sein, von denen die erste und dritte vor dem Abspeichern eine Kennung enthalten. In der zweiten Zwischenspeicherzelle wird das abzuspeichernde Datum eingegeben, nachdem im ersten Zwischenspeicher zuvor die Adresse abgelegt wurde. Danach wird dann in der dritten Zwischenpeicherzelle eine Zwischenkennung abgelegt und im vierten Speicherschritt erfolgt dann das Abspeichern des Datums in der gewünschten Adresse. In zwei nachfolgenden weiteren Speicherschritten werden dann in die erste Zwischenpeicherzelle und in die zweite Zwischenspeicherzelle wieder die ursprünglichen Kennungen abgespeichert. Ein solcher Speicherzyklus umfaßt sechs Speicherschritte, wobei jeder Speicherschritt nur an einer Speicherzelle eine Veränderung auslöst. Wird nun während des Speichervorgangs der Speicherzyklus unterbrochen, so kann aufgrund der in den einzelnen Speicherzellen enthaltenen Informationen oder Daten vom Rechner erkannt werden, ob der Inhalt an der gewünschten Adresse korrekt gespeichert wurde oder ob bei diesem Abspeichervorgang durch Spannungsabschaltung möglicherweise eine korrekte Speicherung nicht erfolgen konnte.

Die korrekte Adresse und das zugehörige Datum kann dann bei Einschalten der Spannung aus den dafür vorgesehenen Zwischenspeichern übernommen werden.

Nach dem Anlegen der Versorgungsspannung werden stets die Inhalte der ersten und dritten Speicherzellen überprüft, dann deren Inhalt mit den vorgesehenen Kennungen geladen und gegebenenfalls unter der im ersten Zwischenspeicher abgelegten Adresse der Inhalt des zweiten Zwischenspeichers abgespeichert. Mittels einer sehr einfachen Speicherzellen-Abfrage kann eine Überprüfung der korrekten Speicherung eines Datums durchgeführt werden.

Das erfindungsgemäße Verfahren ist in besonders vorteilhafter Weise in elektronischen Steuerung von Kraftfahrzeugen einsetzbar. Es kann dort vorteilhaft zur Sicherung der Daten eines elektronischen Fahrtenschreibers und/oder auch zur Sicherung der Speichervorgänge von motorspezifischen Daten dienen, die den Motorzustand kennzeichnen. Gerade das Bordnetz von Kraftfahrzeugen ist im Betrieb unterschiedlichen Einflüssen ausgesetzt, die Spannungsschwankungen hervorrufen können. Erreichen diese Spannungsschwankungen Werte, die eine Datenübertragung stören können, so kann mit dem erfindungsgemäßen Verfahren nach Auftreten einer solchen Störung eindeutig erkannt werden, wo ein Speichervorgang nicht korrekt abgeschlossen werden konnte so daß dieser gestörte Speichervorgang gegebenenfalls nochmals wiederholt werden kann. Weiterhin ist von besonderer Bedeutung, daß mit dem erfindungsgemäßen Verfahren auch beim Abschalten der Zündung und dem gleichzeitig auftretenden Abschalten der Versorgungsspannung eine dadurch bedingte unkorrekte Datenübertragung erkannt und eine falsche Datenabspeicherung vermieden wird.

### Zeichnung

Die Erfindung wird nachfolgend anhand der Zeichnung näher erläutert. Es zeigen:

Figur 1 ein Flußdiagramm des Speichervorganges,

Figur 2 einige Speicherzellen eines in Zwischenspeicher und Hauptspeicher unterteilten nichtflüchtigen Speichers und

Figur 3 den grundsätzlichen Aufbau eines Steuergerätes mit nichtflüchtigem Speicher.

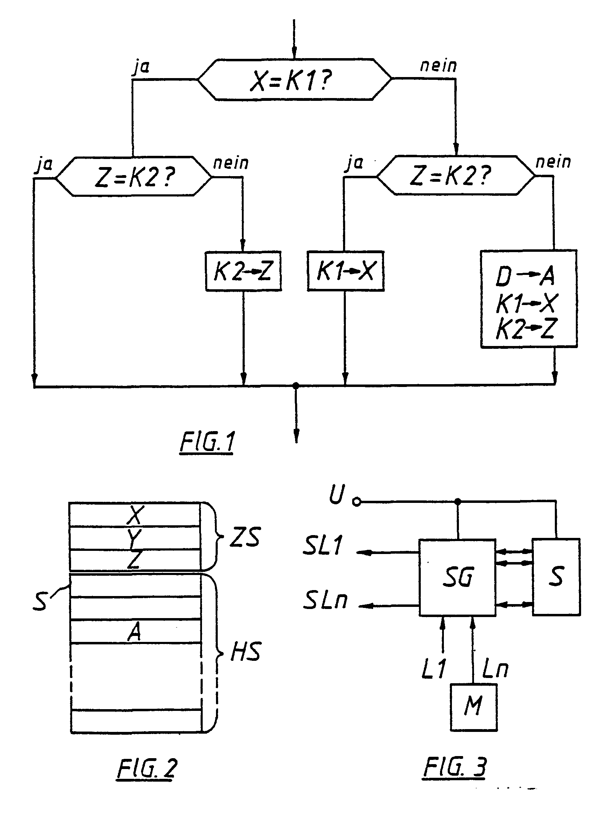

Anhand des in Figur 1 dargestellten Flußdiagramms und der in Figur 2 dargestellten Speicherzellen wird der Speichervorgang erläutert. Zur Sicherung und Wiederherstellung eines durch Abschalten der Versorgungsspannung verlorengegangenen Inhalts einer Speicherzelle werden als Zwischenspeicher ZS drei Speicherzellen X, Y, Z verwendet. Die in nachfolgender Tabelle angegebene Adresse A gibt die Adresse an, wo das Datum D in einem Hauptspeicher HS abgespeichert werden soll.

| | X | Y | Z | A |
|---|---|---|---|---|
| Anfang | K1 | ? | K2 | ? |
| 1. | A | ? | K2 | ? |
| 2. | A | D | K2 | ? |
| 3. | A | D | K0 | ? |
| 4. | A | D | K0 | D |
| 5. | K1 | D | K0 | D |
| 6. | K1 | D | K2 | D |

Als Haupt- und Zwischenspeicher kann beispielsweise ein EEPROM vorgesehen sein, in dem die drei Zwischenspeicherzellen die Adressen, X, Y und Z haben. In der Speicherzelle X wird anfangs die Kennung K1, in der Speicherzelle Z die Kennung K2 gespeichert. Ist ein Datum D unter der Adresse A zu speichern, so geschieht dies folgendermaßen:

1. In der Speicherzelle Z wird die Adresse A abgespeichert.

2. In der Speicherzelle Y wird das Datum D abgespeichert.

3. In der Speicherzelle Z wird die Kennung K0 abgespeichert.

4. In der Speicherzelle A wird das Datum D abgespeichert, was das eigentliche Abspeichern darstellt.

5. In der Speicherzelle X wird die Kennung K1 abgespeichert.

6. In der Speicherzelle Z wird die Kennung K2 abgespeichert.

Die Kennung K1 muß von allen möglichen Adressen A des Speichers verschieden sein und es muß die Zwischenkennung K0 verschieden sein von K2. Die Kennungen K1 und K2 können jedoch gleich sein. Es ist zu beachten, daß jeder der Schritte 1 bis 6 durch Abschalten der Spannung unterbrochen werden kann, was eventuell dazu führen kann, daß der Inhalt der jeweils gerade zu beschreibenden Speicherzelle X, Y, Z, A zerstört wird.

Jedesmal nach dem Anlegen der Spannung werden die Speicherzellen X und Z in einer Initialisierungs-Routine überprüft (siehe Zeichnung).

Enthält die Speicherzelle X die Kennung K1, so kann nach Beendigung von Schritt 1 bis Beendigung von Schritt 5 der letzten erfolgten Abspeicherung keine Unterbrechung stattgefunden haben, d.h. außer den Speicherzellen X, Y und Z sind alle übrigen Speicherzellen-Inhalte unzerstört. Um den korrekten Anfangszustand von X und Z herzustellen, wird in Speicherzelle Z die Kennung K2 gespeichert, falls Speicherzelle Z nicht ohnehin schon die Kennung K2 enthält.

Enthält die Speicherzelle X nicht die Kennung K1, aber Speicherzelle Z die Kennung K2, so kann nach Beendigung von Schritt 3 bis Beendigung von Schritt 6 der letzten erfolgten Abspeicherung keine Unterbrechung stattgefunden haben, d.h., daß abgesehen von den Speicherzellen X, Y und Z alle Speicherzellen-Inhalte unzerstört sind. Um den korrekten Anfangszustand von X und Z herzustellen, wird in die Speicherzelle X die Kennung K1 gespeichert.

Enthält dagegen die Speicherzelle X nicht die Kennung K1 und die Speicherzelle z, nicht die Kennung K2, so ist zwischen Beendigung von Schritt 3 und Beendigung von Schritt 5 eines wie obene beschriebenen Abspeichervorganges die Spannung abgeschaltet worden. Speicherzelle X enthält dann die Adresse A und die Speicherzelle Y das dort abzuspeichernde Datum D. Der Schritt 4 ist in diesem Fall möglicherweise unterbrochen worden. Der Inhalt der Speicherzelle A ist somit fraglich. Aus diesem Grunde wird der abgesprochene Abspeichervorgang nun mit Schritt 4, 5 und 6 abgeschlossen. Die hierfür benötigten Werte für die Adresse A und das Datum D stehen in den Speicherzellen X und Y zur Verfügung.

Die nach dem Abschalten vorgenommene Initialisierungs-Routine erfolgt gemäß Zeichnung in der Weise, daß zunächst geprüft wird, ob der Inhalt von der Speicherzelle X gleich K1 ist. Ist dies der Fall, so wird geprüft ob der Inhalt von Z gleich K2 ist. Ist Z=K2, so ist die Initialisierungs-Routine abgeschlossen, ist dagegen Z nicht gleich K2, so wird K2 nach Z gespeichert.

Wird nach dem Start der Initialisierungs-Routine festgestellt, daß die Speicherzelle nicht gleich K1 ist, so wird geprüft ob Z gleich K2 und wenn ja, wird K1 nach X gespeichert. Ist Z nicht gleich K2, wird D von Y nach A, dann K1 nach Z und daraufhin K2 nach Z abgespeichert. Die Initialisierungs-Routine ist dann abgeschlossen.

In Figur 3 ist der grundsätzliche Aufbau eines Steuergerätes SG mit zugeordnetem nichtflüchtigen Speicher S angegeben. Das Steuergerät SG wird ebenso wie der Speicher S von der Batteriespannung U versorgt. Das Steuergerät SG ist über mehrere Datenleitungen mit Sensoren oder anderen Gebern verbunden, die am Motor M oder an anderen au überwachenden Einrichtungen angeordnet sein können. Das Steuergerät SG verarbeitet die empfangenen Daten und speichert diese soweit erforderlich im Speicher S ab. Aufgrund gespeicherter Daten und aktueller Daten nimmt das Steuergerät SG die Steuerungsaufgaben war, wobei die erforderlichen Steuersignale über Steuerleitungen SL1 bis SLn zu den entsprechenden Einrichtungen übertragen werden.

**Pantentansprüche**

1. Verfahren zum Abspeichern von Daten in nichtflüchtige Speicher zu Sicherung gegen Datenverlust bei Spannungsänderung der Betriebsspannung während eines Speichervorganges, dadurch gekennzeichnet, daß ein nichtflüchtiger Zwischenspeicher (ZS) vorgesehen ist, in dem die zu speichernden Daten (D) und zugehörigen Adressen (A) und Kennungen (K0, K1, K2) über den Stand des Speichervorganges abgelegt sind, und daß die gespeicherten Daten (D) so lange in einen Hauptspeicher (HS) übertragen werden, bis aufgrund der Kennungen (K0 bis K2) eine sichere Speicherung der Daten (D) im Hauptspeicher (HS) signalisiert ist.

2. Verfahren nach Anspruch 1, dadurch gekennzeichnet, daß der Speichervorgang abgebrochen wird, wenn aufgrund der Kennungen (K0 bis K2)

die zu speichernden Daten (D) im Zwischenspeicher (ZS) unvollständig sind.

3. Verfahren nach einem der Ansprüche 1 oder 2, dadurch gekennzeichnet, daß mindestens zwei Kennungen vorgesehen sind, von denen die eine die richtige Übernahme in den Zwischenspeicher (ZS) und die andere den Abschluß des im Hauptspeicher (HS) erfolgten Speichervorganges erkennbar macht.

4. Verfahren nach einem der vorhergehenden Ansprüche, dadurch gekennzeichnet, daß als Zwischenspeicher (ZS) drei Speicherzellen (X, Y, Z) vorgesehen sind, deren erste und dritte Speicherzelle (X, Z) vor jedem Speichervorgang eine Kennung (K1, K22 enthalten, daß zu Beginn des Speichevorganges in der ersten Speicherzelle (X) zunächste die Adresse (A), dann in der zweiten Speicherzelle (Y) der zugehörige Inhalt (D) und danach in der dritten Speicherzelle (Z) eine Zwischenkennung (K0) gespeichert werden, daß dann der Inhalt der zweiten Speicherzelle unter der in der ersten Speicherzelle (X) zwischengespeicherten Adresse (A) im Hauptspeicher (HS) abgelegt wird, und daß dann in der ersten und dritten Speicherzelle (X, Z) nacheinander wieder die ursprünglichen Kennungen (K1, K2) abgespeichert werden.

5. Verfahren nach Anspruch 4, dadurch gekennzeichnet, daß immer nach dem Anlegen der Versorgungsspannung zunächst die Inhalte der ersten und dritten Speicherzelle (X, Z) überprüft, dann deren Inhalte mit den vorgesehenen Kennungen (K1, K2) geladen werden und gegebenenfalls unter der in der ersten Speicherzelle (X) abgelegten Adresse (A) der Inhalt (D) der zweiten Speicherzelle (Y) abgespeichert wird.

**Revendications**

1. Procédé de mémorisation de données dans une mémoire non volatile pour se protéger contre la perte de données en cas de modification de la tension de fonctionnement pendant un processus de mémorisation, procédé caractérisé en ce qu'il est prévu une mémoire intermédiaire (ZS) non volatile, dans laquelle sont déposées les données (D) à mémoriser et les adresses (A) correspondantes, ainsi que des indications (K0, K1, K2) sur l'état du processus de mémorisation, et en ce que les données (D) ainsi mémorisées sont transférées dans une mémoire principale (HS) jusqu'à ce que, sur la base des indications (K0 à K2), une mémorisation sûre des données (D) dans la mémoire principale (HS) soit signalée.

2. Procédé selon la revendication 1, caractérisé en ce que le processus de mémorisation est arrêté, lorsque sur la base des indications (K0 à K2) les données (D) à mémoriser dans la mémoire intermédiaire (ZS) sont incomplètes.

3. Procédé selon une des revendications 1 ou 2, caractérisé en ce qu'il est prévu au moins deux indications, dont l'une permet de reconnaître la prise en charge correcte dans la mémoire intermédiaire (ZS) et l'autre la conclusion du processus de mémorisation se déroulant dans la mémoire principale (HS).

4. Procédé selon une des précédentes revendications, caractérisé en ce qu'il est prévu comme mémoire intermédiaire (ZS) trois cellules de mémoire (X, Y, Z), la première et la troisième (X, Z) de ces cellules de mémoire contenant avant chaque processus de mémorisation une indication (K1, K2), en ce qu'au début du processus de mémorisation, tout d'abord l'adresse (A) est mémorisée dans la première cellule de mémoire (X), puis le contenu correspondant (D) est mémorisé dans la second cellule de mémoire (Y), et ensuite une indication intermédiaire (K0) est mémorisée dans la troisième cellule de mémoire (Z), en ce qu'ensuite le contenu de la seconde cellule de mémoire est déposé dans la mémoire principale (HS) sous l'adresse (A) mémorisée de façon intermédiaire dans la première cellule de mémoire (X), et en ce qu'ensuite les indications initiales (K1, K2) sont à nouveau successivement mémorisées dans la première et la troisième cellules de mémoire (X, Z).

5. Procédé selon la revendication 4, caractérisé en ce que, après que la tension d'alimentation ait été établie, les contenus de la première et de la troisième cellule de mémoire (X, Z) sont vérifiés, puis les contenus de ces cellules sont chargés avec les indications prévues (K1, K2) et éventuellement le contenu (D) de la seconde cellule de mémoire (Y) est mémorisé sous l'adresse (A) déposée dans la première cellule de mémoire (X).

**Claims**

1. Process for storing data in non-volatile memories for providing protection against data loss in the case of voltage change of the operating voltage during a storage procedure, characterized in that a non-volatile intermediate memory (ZS) is provided, in which the data (D) to be stored and associated addresses (A) and identifications (K0, K1, K2) relating to the state of the storage procedure are deposited, and in that the stored data (D) are transmitted into a main memory (HS) until, on the basis of the identifications (K0 to K2), a secure storage of the data (D) in the main memory (HS) is signalled.

2. Process according to Claim 1, characterized in that the storage procedure is broken off, if, on the basis of the identifications (K0 to K2), the data (D) to be stored in the intermediate memory (ZS) are incomplete.

3. Process according to one of Claims 1 or 2, characterized in that at least two identifications are provided of which the one identifies the correct transferral into the intermediate memory (ZS) and the other identifies the termination of the storage procedure which has occurred in the main memory (HS).

4. Process according to one of the preceding claims, characterized in that, as intermediate memory (ZS), three memory cells (X, Y, Z) are provided, the first and third memory cell (X, Z) of which contain an identification (K1, K2) before each storage procedure, in that, at the beginning of the storage procedure, first the address (A) is stored in the first memory cell (X), then the associated contents (D) are stored in the second memory cell (Y) and then an intermediate identification (K0) is stored in the third memory cell (Z), in that the contents of the second memory cell are then deposited in the main memory (HS) at the address (A) which was buffered in the first memory cell (X), and in that then the original identifications (K1, K2) are again successively stored in the first and third memory cell (X, Z).

5. Process according to Claim 4, characterized in that always after the application of the supply voltage, initially the contents of the first and third memory cell (X, Z) are tested, then their contents are loaded with the identifications (K1, K2) provided and if appropriate the contents (D) of the second memory cell (Y) are stored in the address (A) stored in the first memory cell (X).

FIG.1

FIG. 2

FIG. 3